# EUROPEAN PATENT APPLICATION

(11) **EP 4 492 134 A1**
(43) Date of publication of application: **15.01.2025**
(21) Application number: 23766444.6
(22) Date of filing: 15.02.2023
(51) Int. Cl.: G03B 19/16, G02B 5/00, G03B 15/00, G03B 17/02, H01L 27/146, H04N 23/55, H04N 25/00

(54) **IMAGING DEVICE**

(30) Priority: 07.03.2022 JP 2022034563
(71) Applicant: Sony Group Corporation, Tokyo 108-0075 (JP)
(72) Inventor: SHIGEI, Hiroyuki, Tokyo 108-0075 (JP); TAKAHASHI, Teppei, Tokyo 108-0075 (JP)
(74) Representative: 2SPL Patentanwälte PartG mbB
(86) International application number: PCT/JP2023/005141
(87) International publication number: WO 2023/171264

(57) **Abstract**

An imaging device includes a light guide plate, a light shielding film, and an appearance component (20). The light guide plate includes a frustum-shaped protrusion (12). The light shielding film covers a surface of the protrusion, the surface being other than the flat face (12A) of the top of the protrusion (12). The appearance component (20) covers the upper portion of the light guide plate in a state where the flat face (12A) of the protrusion is exposed to the outside.

## Description

### Field

The present invention relates to an imaging device.

### Background

There has been proposed an imaging device in which a pinhole having a size that is invisible and does not affect a texture of a surface is opened on a surface of a design material (an appearance component) such as wood or leather to improve designability. An imaging device including a pinhole is disclosed in Patent Literature 1 and the like.

### Citation List

### Patent Literature

Patent Literature 1: JP 2016-025164 A

### Summary

### Technical Problem

The image quality of the imaging device changes depending on the processing accuracy of the pinhole. In order to ensure processing accuracy, it is necessary to adjust a processing method for each of the appearance components. In addition, image quality is deteriorated due to degradation of the inside of the pinhole (peeling of leather material and wood, etc.) and mixing of moisture and dust into the inside of the pinhole.

Therefore, the present disclosure proposes an imaging device capable of improving image quality.

### Solution to Problem

According to the present disclosure, an imaging device is provided that comprises: a light guide plate having a frustum-shaped protrusion; a light shielding film covering a surface of the protrusion, the surface being other than a flat face of a top of the protrusion; and an appearance component covering an upper portion of the light guide plate in a state where the flat face of the protrusion is exposed to an outside.

### Brief Description of Drawings

FIG. 1 is a diagram for describing a background of the present disclosure.
FIG. 2 is a diagram illustrating an example of an imaging device of the present disclosure.
FIG. 3 is a diagram illustrating a configuration of an optical component.
FIG. 4 is a diagram illustrating a configuration of an optical component.
FIG. 5 is a diagram illustrating a configuration of an optical component.
FIG. 6 is a diagram illustrating a configuration of an optical component.
FIG. 7 is a view illustrating an example of a shape of an upper end portion of a light shielding film, the upper end portion being adjacent to a flat face.
FIG. 8 is a view illustrating an example of a shape of an upper end portion of a light shielding film, the upper end portion being adjacent to a flat face.
FIG. 9 is a view illustrating an example of a shape of an upper end portion of a light shielding film, the upper end portion being adjacent to a flat face.
FIG. 10 is a diagram illustrating an example of adhesion of an appearance component.
FIG. 11 is a diagram illustrating an example of adhesion of an appearance component.
FIG. 12 is a diagram illustrating an example of adhesion of an appearance component.
FIG. 13 is a view illustrating a modification of a protrusion.
FIG. 14 is a view illustrating a modification of a protrusion.
FIG. 15 is a view illustrating a modification of a protrusion.
FIG. 16 is a view illustrating a modification of a protrusion.
FIG. 17 is a view illustrating an example in which the light guide plate includes a plurality of protrusions.
FIG. 18 is a view illustrating an example in which the light guide plate includes a plurality of protrusions.
FIG. 19 is a view illustrating an example in which the light guide plate includes a plurality of protrusions.
FIG. 20 is an explanatory diagram of an imaging device including a luminance adjustment filter.
FIG. 21 is an explanatory diagram of an imaging device including a luminance adjustment filter.
FIG. 22 is an explanatory diagram of an imaging device including a luminance adjustment filter.
FIG. 23 is a diagram illustrating application to an omnidirectional camera.
FIG. 24 is a diagram illustrating application to an omnidirectional camera.
FIG. 25 is a diagram illustrating application to an omnidirectional camera.
FIG. 26 is a diagram illustrating an application example of an imaging device.
FIG. 27 is a diagram illustrating an application example of an imaging device.
FIG. 28 is a diagram illustrating an application example of an imaging device.
FIG. 29 is a diagram illustrating an application example of an imaging device.
FIG. 30 is a diagram illustrating an application example of an imaging device.

### Description of Embodiments

Hereinafter, the embodiments of the present disclosure will be described in detail with reference to the drawings. In the following embodiments, the same parts are denoted by the same reference signs, and a duplicate description will be omitted.

Note that the description will be given in the following order.
[1. Background]
[2. Configuration of imaging device]
   [2-1. Configuration of optical component]
   [2-2. End shape of light shielding film]
   [2-3. Adhesion example of appearance component]
   [2-4. Modification of protrusion]
[3. Array of protrusions]
[4. Luminance distribution adjustment filter]
[5. Application to omnidirectional camera]
[6. Application example of imaging device]
[7. Effects]

### [1. Background]

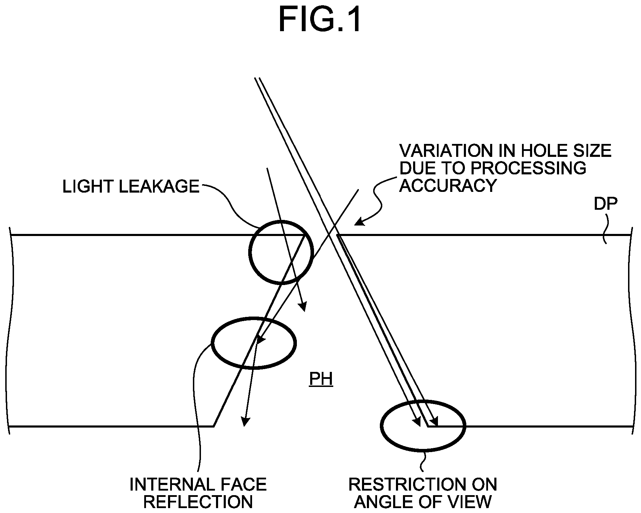

FIG. 1 is a diagram for describing a background of the present disclosure.

An imaging device (a pinhole camera or a photon sieve camera) including a design material DP such as wood or leather on a surface is studied. In order to enhance the designability, a pinhole PH (for example, the diameter is 100 µm or less) having a size that is invisible and does not affect the texture of the surface is opened in the design material DP. When a thick material is used for the design material DP, a method of tapering the pinhole PH to obtain an angle of view has been proposed. However, this method has the following problems.
(i) Since the image quality changes depending on the processing accuracy of the design material DP, it is necessary to study a processing method for each design material DP.
(ii) Light leakage from the periphery of the pinhole PH causes degradation in image quality.
(iii) The angle of view is restricted by the taper angle of the pinhole PH.
(iv) Image quality deteriorates due to reflection on the inner wall portion of the pinhole PH.
(v) The pinhole PH is required to be filled with a transparent material for waterproofing and antifouling.

The present disclosure has been made in view of the above problems. In the present disclosure, an optical component is fitted into a pinhole PH opened in the design material DP, and light is supplied from only the optical component to the imaging element. In this configuration, stable image quality can be obtained even if the processing accuracy of the design material DP is low. Waterproof and antifouling are achieved by fitting the optical component into the pinhole PH, and image quality degradation due to reflection on the inner wall portion of the pinhole PH does not occur. Hereinafter, a specific description will be given.

### [2. Configuration of imaging device]

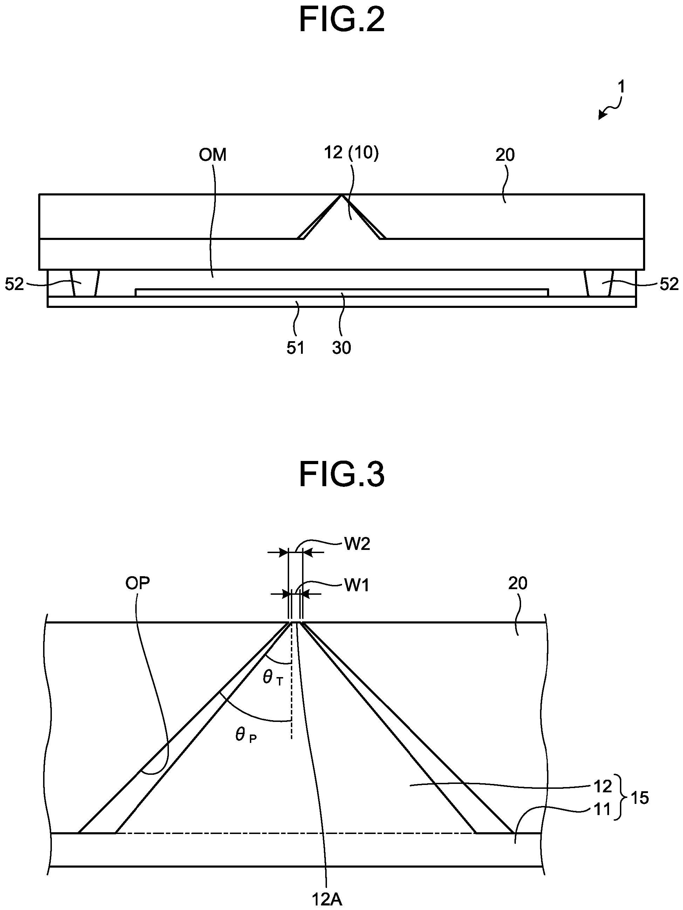

FIG. 2 is a diagram illustrating an example of an imaging device 1 of the present disclosure.

The imaging device 1 includes an optical component 10, an appearance component 20, and an imaging element 30. The optical component 10 has one or more protrusions 12 serving as light incident portions. The appearance component 20 is a component constituting the appearance of the imaging device 1. The appearance component 20 covers a region other than the incident face of the protrusion 12. As the appearance component 20, a material (design material) having a design function, such as wood or leather, is used.

The imaging element 30 is mounted on a substrate 51. Substrate 51 is disposed to face the optical component 10 with a spacer 52 interposed therebetween. An optical layer OM is disposed in a gap between the imaging element 30 and the optical component 10. The optical layer OM has a function of refracting or diffracting the light transmitted through the optical component 10. The light incident on the protrusion 12 is incident on the imaging element 30 via the optical component 10 and the optical layer OM. Examples of the imaging element 30 include a complementary metal oxide semiconductor (CMOS) sensor, a charge coupled device (CCD) sensor, and the like.

### [2-1. Configuration of optical component]

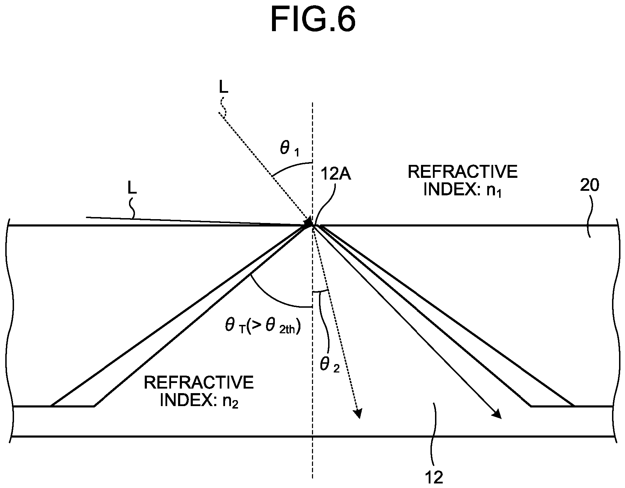

FIGS. 3 to 6 are diagrams for describing the configuration of the optical component 10.

The optical component 10 includes a light guide plate 15 and a light shielding film 16. The light guide plate 15 has one or more protrusions 12 on a transparent plate 11. The transparent plate 11 and the protrusion 12 are integrally formed of, for example, a transparent material. The term "transparent" means transparent to light (for example, visible light) with which an object is imaged. An example of the transparent material includes glass.

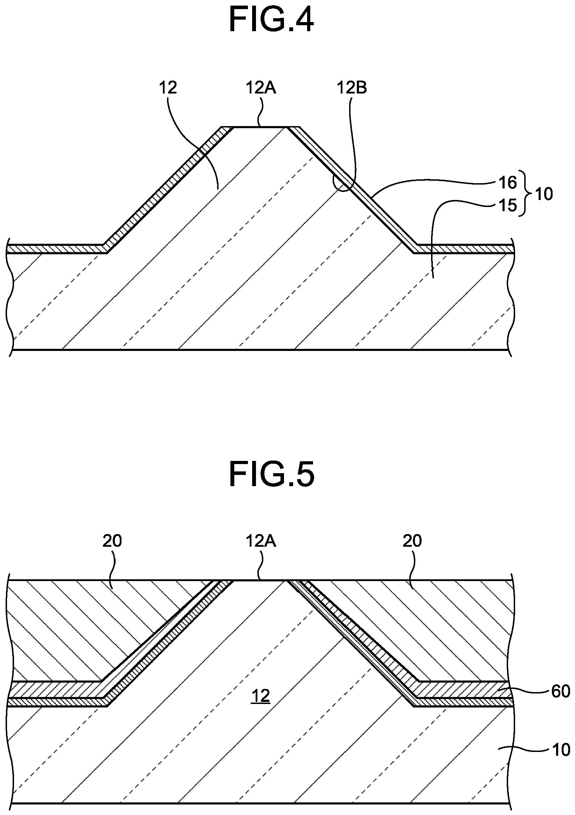

The protrusion 12 has a frustum shape such as a truncated cone or a truncated pyramid. The top of the protrusion 12 is a flat face 12A, and the flat face 12A is an incident face of light. The imaging element 30 receives light incident from the flat face 12A of the protrusion 12. The light shielding film 16 covers a surface of the protrusion 12, the surface being other than the flat face 12A. In the example of FIG. 4, the light shielding film 16 continuously covers the surface of the light guide plate 15 (transparent plate 11) around the protrusion 12 from a side face 12B of the protrusion 12.

The appearance component 20 covers the upper portion of the light guide plate 15 in a state where the flat face 12A of the protrusion 12 is exposed to the outside. The appearance component 20 has an opening OP into which the protrusion 12 is fitted. The opening OP has a tapered shape in which the bottom face side opening area facing the light guide plate 15 is larger than the upper face side opening area. A taper angle θ_{P} of the opening OP is larger than a taper angle θ_{T} of the protrusion 12.

A taper angle θ_{T} of the protrusion 12 is larger than a critical angle θ₂ₜₕ of light (for example, a wavelength of 530 nm) incident on the flat face 12A of the protrusion 12. n₁ × sinθ₁ = n₂ × sinθ₂ holds (Snell's law) is established, where n₁ is a refractive index of the outside of the imaging device 1, n₂ is a refractive index of the protrusion 12, θ₁ is an incident angle on the flat face 12A, and θ₂ is a refractive angle at the flat face 12A. Since the critical angle θ₂ₜₕ is the refractive angle θ₂ when the incident angle θ₁ is 90°, θ₂ₜₕ = sin⁻¹ (n₁/n₂). When n₁ = 1 (air) and n₂ = 1.54 (glass), θ₂ₜₕ ≈ 40.5°. Therefore, the taper angle θ_{T} of the protrusion 12 is set to, for example, 45°.

For example, the shape of the protrusion 12 is a truncated cone. The appearance component 20 has a circular opening OP through which the circular flat face 12A is exposed. The upper face side opening area of the opening OP is larger than the area of the flat face 12A of the protrusion 12. For example, the diameter W1 of the flat face 12A is 50 µm, and the diameter W2 of the upper face side opening face of the opening OP is 80 µm.

An adhesive layer 60 is provided between the inner face of the opening OP and the side face 12B (light shielding film 16) of the protrusion 12. The adhesive layer 60 bonds the appearance component 20 and the optical component 10 together, and prevents moisture and dust from entering a gap between the appearance component 20 and the optical component 10.

### [2-2. End shape of light shielding film]

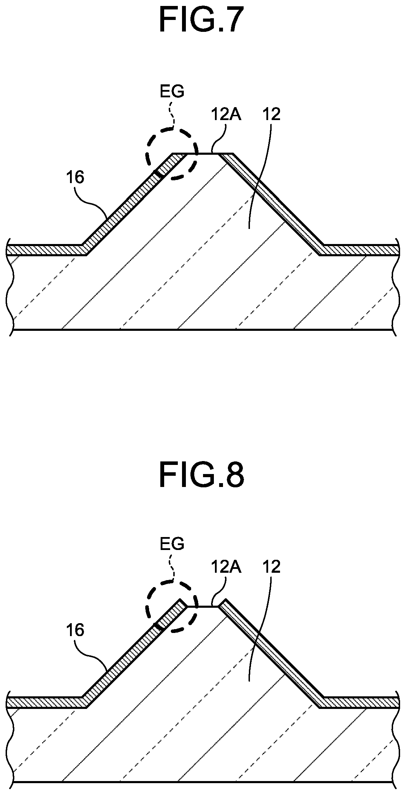

FIGS. 7 to 9 are diagrams illustrating an example of the shape of an upper end portion EG of the light shielding film 16, the upper end portion being adjacent to the flat face 12A.

In the example of FIG. 7, the upper end portion EG of the light shielding film 16 is a flat face continuous with the flat face 12A. No step is generated between the upper end portion EG of the light shielding film 16 and the flat face 12A. This configuration is obtained, for example, by forming the light shielding film 16 on the surface of the conical protrusion and then cutting the upper end portion of the protrusion together with the light shielding film 16 in the horizontal direction.

In the example of FIG. 8, the upper end portion EG of the light shielding film 16 has a shape raised relative to the flat face 12A. This configuration is obtained, for example, by forming the frustum-shaped protrusion 12 and then spraying a light shielding material onto the side face 12B of the protrusion 12 using ink jet or the like. The frustum-shaped protrusion 12 is formed using, for example, an imprinting technique. The imprinting technique is a technique for transferring a fine pattern by imprinting a mold (mold) as an original plate.

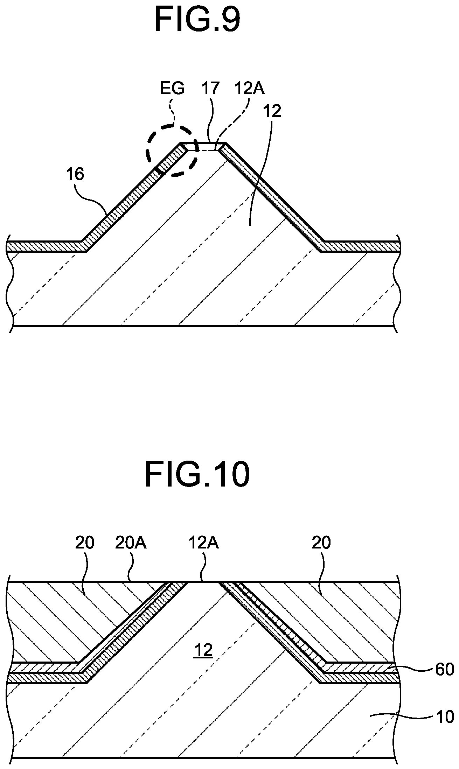

In the example of FIG. 9, as in the example of FIG. 8, the upper end portion EG of the light shielding film 16 has a shape raised relative to the flat face 12A. In the example of FIG. 9, a flattening layer 17 for flattening the step between the upper end portion EG of the light shielding film 16 and the flat face 12A is provided on the flat face 12A. This configuration is obtained, for example, by applying a transparent resin such as acrylic to a region surrounded by the light shielding film 16.

### [2-3. Adhesion example of appearance component]

FIGS. 10 to 12 are diagrams illustrating adhesion examples of the appearance component 20.

In the example of FIG. 10, an upper face 20A of the appearance component 20, the upper face being adjacent to the flat face 12A, is a flat face continuous with the flat face 12A. No step is formed between the upper face 20A of the appearance component 20 and the flat face 12A. This configuration is obtained, for example, by forming the light shielding film 16 on the surface of the conical protrusion, covering the appearance component 20 from above the protrusion, and then cutting the upper end portion of the protrusion together with the appearance component 20 in the horizontal direction.

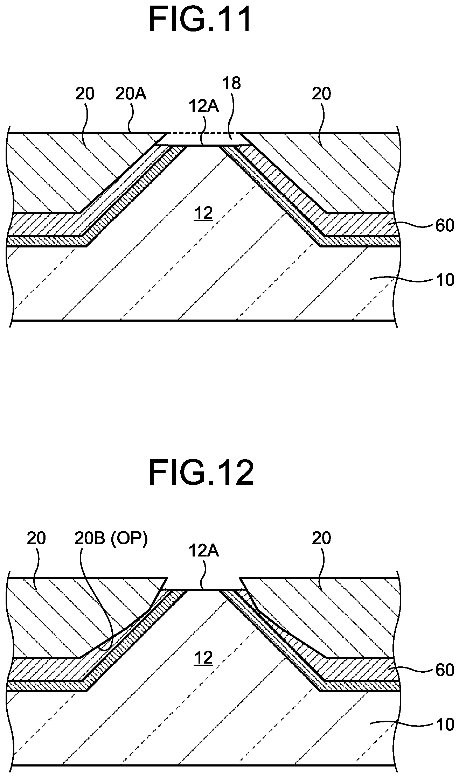

In the examples of FIGS. 11 and 12, the upper face 20A of the appearance component 20 protrudes upward from the flat face 12A. This configuration is obtained, for example, by separately forming the optical component 10 and the appearance component 20, and bonding these components with the adhesive layer 60. A flattening layer 18 for flattening a step between the upper face 20A of the appearance component 20 and the flat face 12A may be provided on the flat face 12A.

In the example of FIG. 12, the taper angle of the opening OP of the appearance component 20 is not constant, and the taper angle decreases (that is, an inner wall face 20B of the opening OP is nearly vertical.) toward the upper portion. Since high processing accuracy is not required for the appearance component 20, such an appearance component 20 can also be applied to the imaging device 1.

### [2-4. Modification of protrusion]

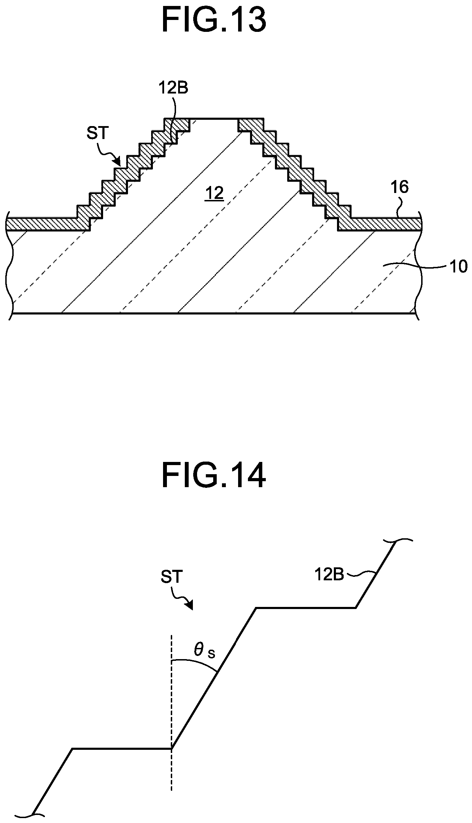

FIGS. 13 to 16 are views illustrating modifications of the protrusion 12.

In the examples of FIGS. 13 and 14, the side face 12B of the protrusion 12 has a stepwise shape. The average taper angle of the side face 12B is larger than the critical angle θ₂ₜₕ. The side face 12B has a plurality of stepped portions ST. The light shielding film 16 is deposited with a uniform thickness along the stepped portion ST. Therefore, the light shielding performance is easily secured. The protrusion 12 can be easily formed by cutting, for example.

The protrusions 12 in FIGS. 13 and 14 can also be formed using an imprinting technique, but in this case, the taper angle θ_{S} of the stepped portion ST is preferably 10° or more. As a result, the protrusion 12 can be easily pulled out from the mold.

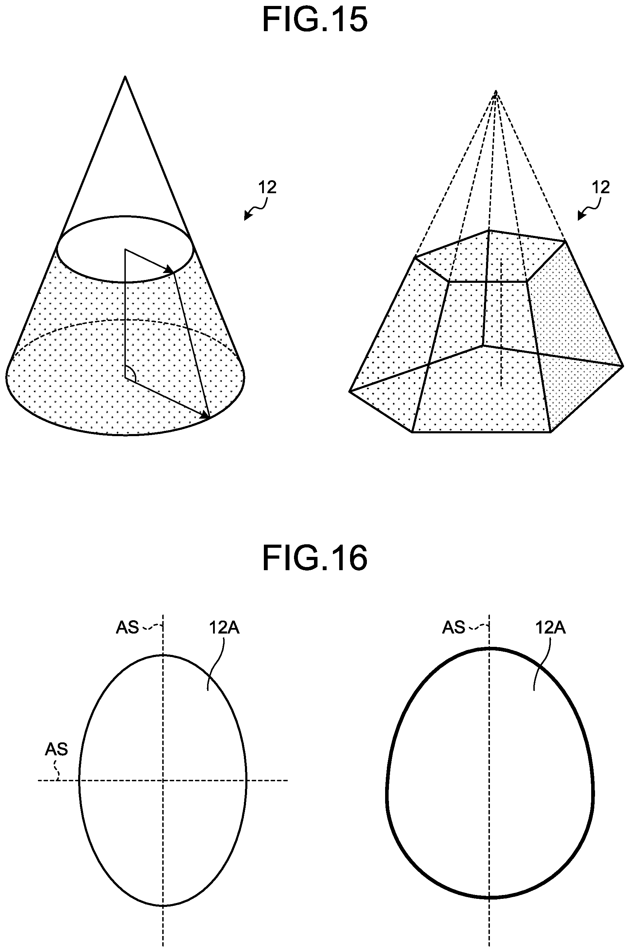

FIGS. 15 and 16 illustrate variations of frustum shapes. The example on the left side of FIG. 15 is an example in which the protrusion 12 has a truncated cone shape. The example on the right side of FIG. 16 is an example in which the protrusion 12 has a truncated pyramid shape.

FIG. 16 illustrates an example in which the flat face 12A of the protrusion 12 has an oval shape. The oval shape means an elongated shape configured by a substantially curved line. In the present disclosure, for example, an oval shape is defined as an elongated shape constituted by all curves having one or more symmetry axes AS. The example on the left side of FIG. 16 is an example in which the flat face 12A has an elliptical shape. The example on the right side of FIG. 16 is an example in which the flat face 12A has an egg shape. By adopting the oval shape, directivity can be given to light receiving performance.

### [3. Array of protrusions]

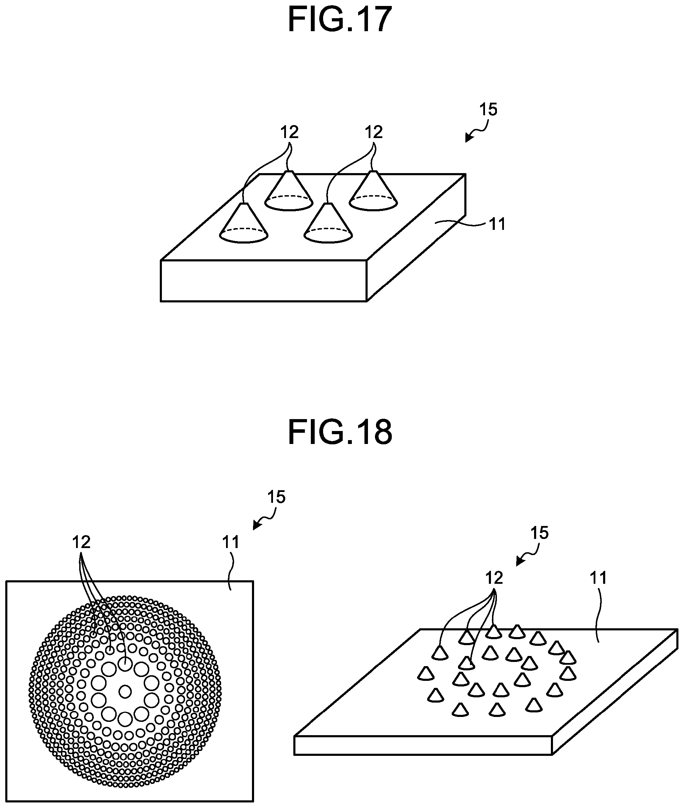

FIGS. 17 to 19 are views illustrating an example in which the light guide plate 15 includes a plurality of protrusions 12.

In the example of FIG. 17, the plurality of protrusions 12 is disposed in an array on the transparent plate 11. In a case where the position of the protrusion 12 is the viewpoint of the camera, images of a plurality of viewpoints are acquired in one photographing. A stereo camera function is realized by using these images.

In the example of FIG. 18, the plurality of protrusions 12 is disposed along a plurality of rings having different diameters from the center. A photon sieve camera is realized by causing each protrusion 12 to function as a hole of a photon sieve.

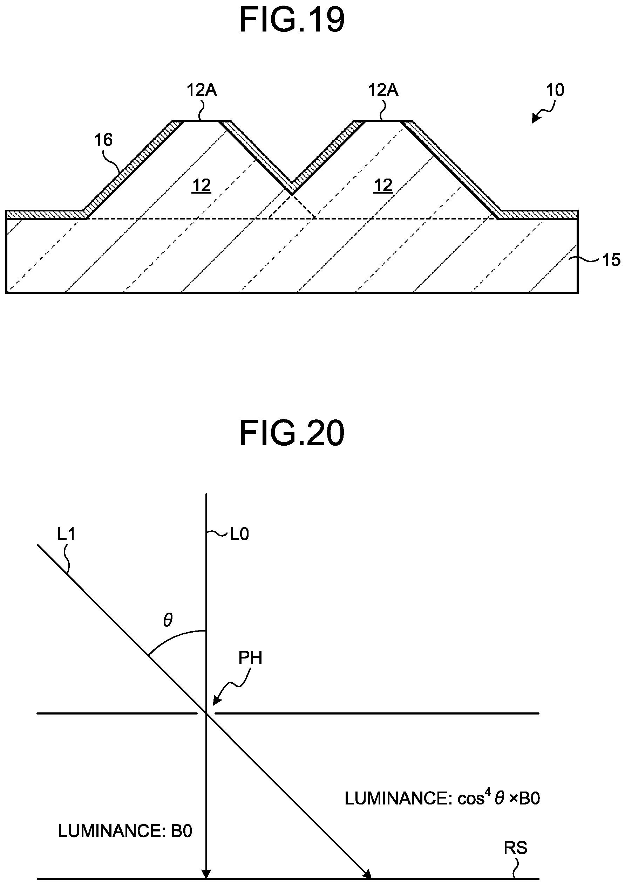

As illustrated in FIG. 19, the plurality of protrusions 12 may be disposed such that the skirt portions overlap each other. This increases the arrangement density of the protrusions 12. Furthermore, the oval shape illustrated in FIG. 16 can also be applied to the examples of FIGS. 17 and 18. As a result, the imaging device 1 having directivity is provided.

### [4. Luminance distribution adjustment filter]

FIGS. 20 to 22 are explanatory diagrams of an imaging device 2 including a luminance adjustment filter 40 on the light incident side of the imaging element 30.

As illustrated in FIG. 20, the luminance of the light incident on a light receiving face RS through the pinhole PH changes depending on the incident angle θ of the light incident on the pinhole PH. The larger the incident angle θ, the smaller the received light luminance. For example, the received light luminance of light L1 incident at the incident angle θ is cos₄θ times received light luminance B0 of light L0 incident at the incident angle 0°. Therefore, when the angle of view is widened, the luminance difference increases between the central portion and the peripheral portion of the imaging element 30. When gain control is performed in accordance with the luminance of the central portion, the peripheral portion is dark, and when gain control is performed in accordance with the luminance of the peripheral portion, white defects occur in the central portion.

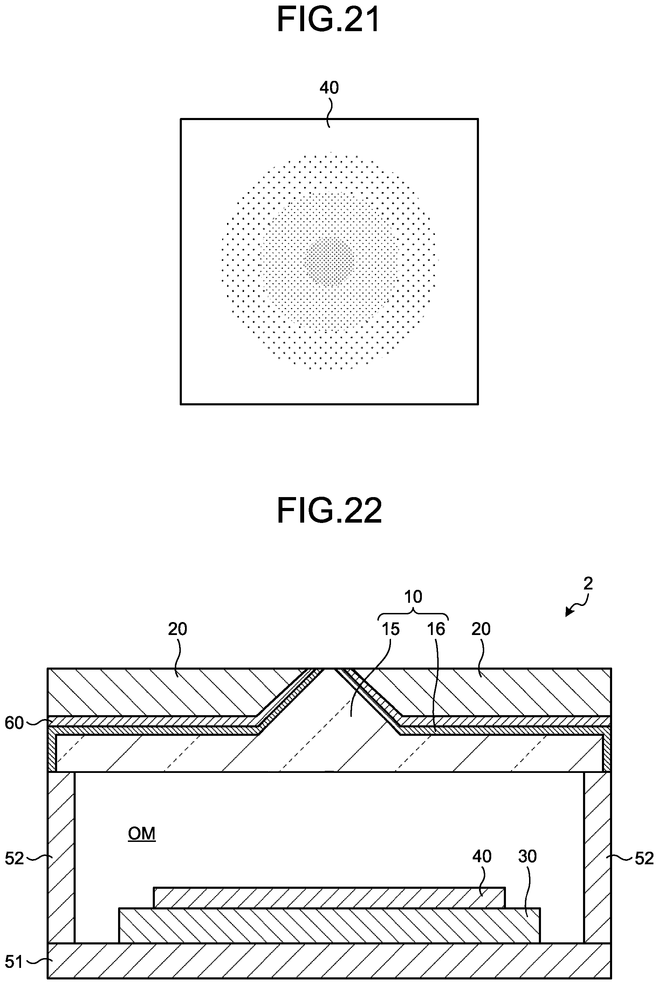

Therefore, the filter 40 as illustrated in FIG. 21 is disposed on the optical path between the protrusion 12 and the imaging element 30. In FIG. 21, color shading indicates light transmittance. The lighter the color, the higher the light transmittance, and the darker the color, the lower the light transmittance. The filter 40 has such optical characteristics that the transmittance of light decreases toward the center. In the present disclosure, light is supplied not through the pinhole PH illustrated in FIG. 20 but through the optical component 10. Therefore, the luminance ratio between the central portion and the peripheral portion may deviate from cos₄θ. Therefore, the filter 40 preferably has a transmittance distribution in consideration of this deviation.

As illustrated in FIG. 22, the filter 40 is stacked on the upper face of the imaging element 30, for example. The light incident on the protrusion 12 is incident on the imaging element 30 via the filter 40. As a result, luminance efficiency of an obtained image is uniform, and gain control can be effectively performed.

### [5. Application to omnidirectional camera]

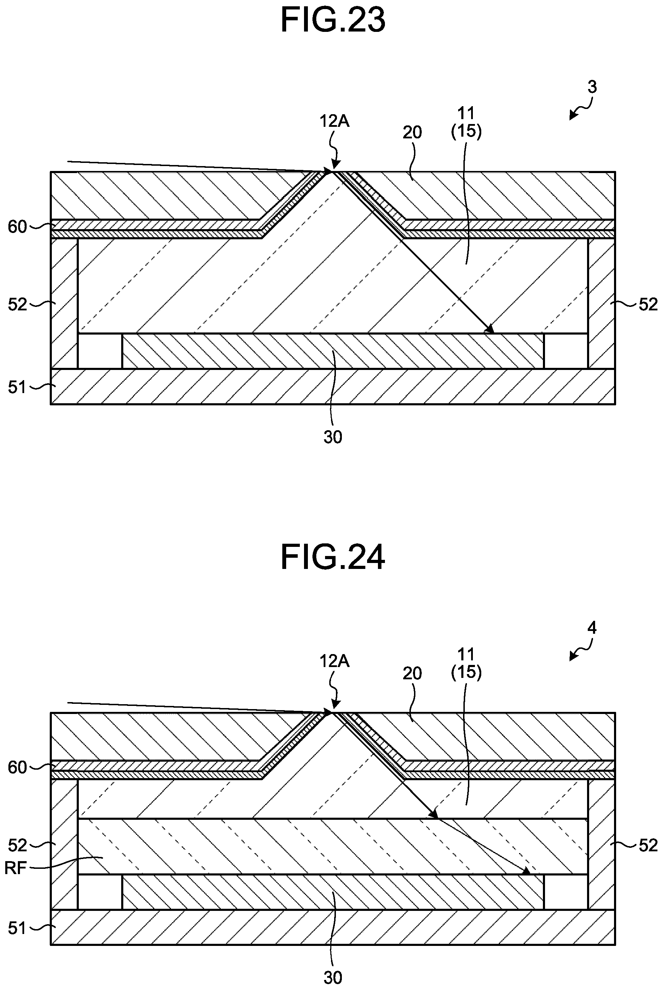

FIGS. 23 to 25 are diagrams illustrating applications to an omnidirectional camera.

In an imaging device 3 of FIG. 23, the back face of the light guide plate 15 is in close contact with the light receiving face of the imaging element 30 directly without via the optical layer OM illustrated in FIG. 2. Even in this configuration, all the light incident on the flat face 12A is incident on the imaging element 30 via the light guide plate 15. Since light incident from all directions is received by the imaging element 30, an omnidirectional camera is realized.

An imaging device 4 in FIG. 24 includes a refractive element RF that refracts the light transmitted through a protrusion 12 toward the imaging element 30 on an optical path between the protrusion 12 and the imaging element 30. The upper face (light incident face) of the refractive element RF is in close contact with the back face of the light guide plate 15, and the lower face of the refractive element RF is in close contact with the light receiving face of the imaging element 30. Even in this configuration, all the light incident on the flat face 12A is incident on the imaging element 30 via the light guide plate 15 and the refractive element RF.

Note that there may be a slight air layer between the light guide plate 15 and the imaging element 30 in FIG. 23. There may be a slight air layer between the refractive element RF and the imaging element 30 in FIG. 24. The refractive element RF of FIG. 24 may include a plurality of layers. When the refractive index of the refractive element RF is greatly different from the refractive index of the light guide plate 15, the thickness of the refractive element RF is desirably thin.

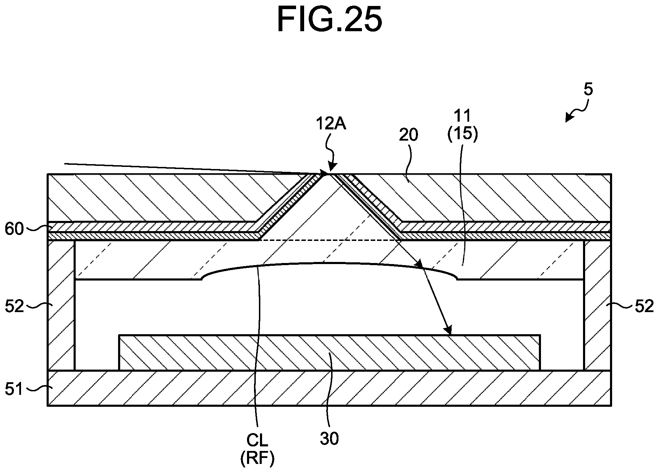

An imaging device 5 in FIG. 25 is an example in which the refractive element RF is a concave lens CL obtained by processing the back face of the light guide plate 15 into a concave shape. Unlike the example of FIG. 24, the light guide plate 15 and the imaging element 30 may not be in close contact with each other. In the example of FIG. 25, an air layer can be formed between the light guide plate 15 and the imaging element 30.

Note that the above-described configurations of the imaging devices 1 to 5 can be used in combination with each other.

### [6. Application example of imaging device]

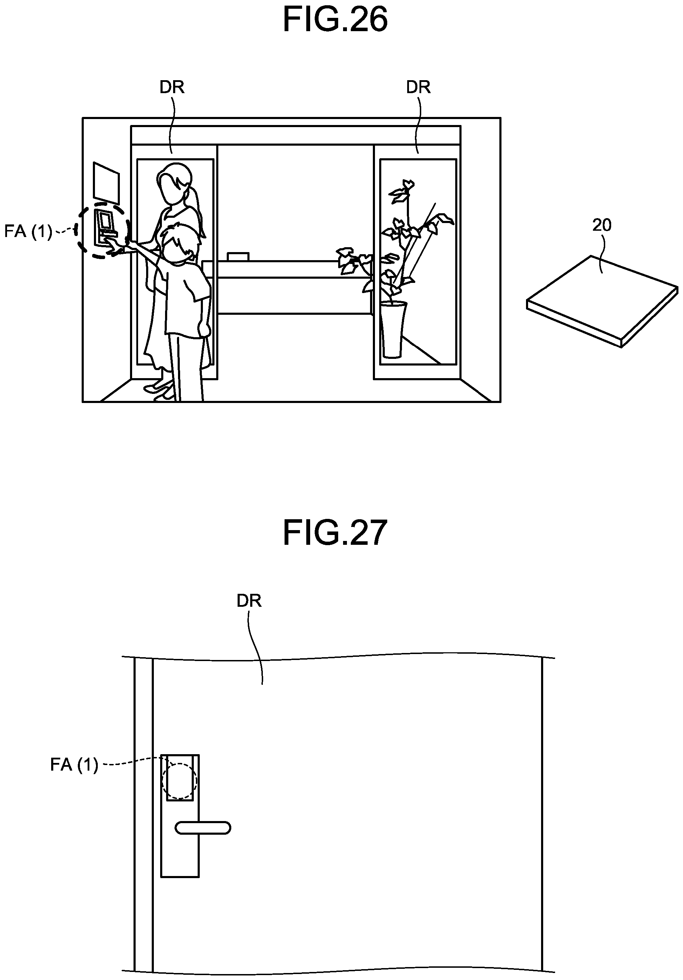

FIGS. 26 to 30 are diagrams illustrating application examples of the imaging device 1.

The example of FIG. 26 is an example in which the imaging device 1 is applied to a fingerprint/palm print authentication device FA installed in an entrance of a building or the like. The fingerprint/palm print authentication device FA includes a wood plate as the appearance component 20. When the registered user holds his/her hand over a wood plate, a door DR opens.

The example of FIG. 27 is an example in which the imaging device 1 is applied to a fingerprint/palm print authentication device FA for unlocking the entrance door DR. The imaging device 1 is disposed in part of a place covered with the material same as that of the door body. The automatic door eliminates the need for a door knob, and a door made of a uniform material can be constructed.

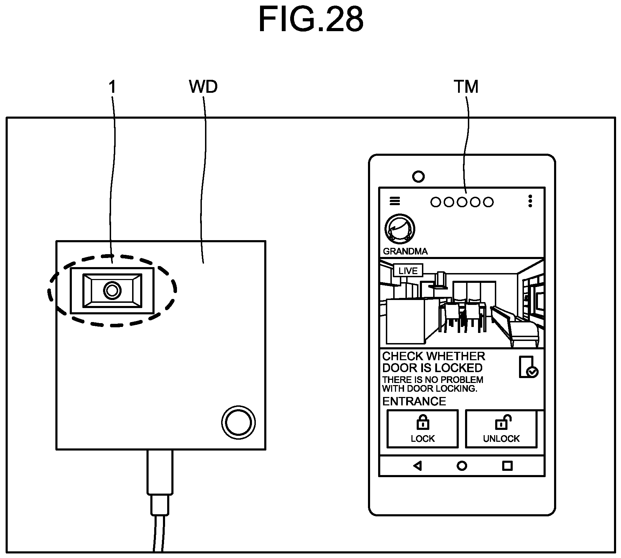

The example of FIG. 28 is an example in which the imaging device 1 is applied to a watching device WD for use in the home. The watching device WD monitors the inside of the room to transmit the monitoring image to a terminal TM such as a smartphone. The camera lens portion in FIG. 28 is hidden by the appearance component 20. When the imaging device 1 is housed in a thick exterior, a lensless image sensor can be constructed.

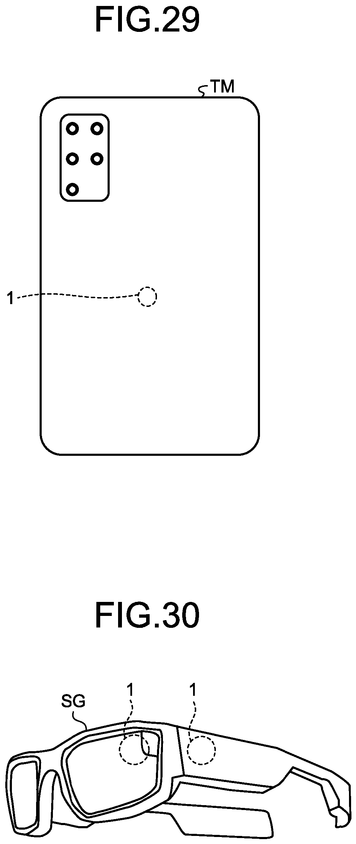

The example of FIG. 29 is an example in which the imaging device 1 is applied to the back face of the terminal TM such as a smartphone. The imaging device 1 is used for face authentication, reading of a QR code (registered trademark), and the like. The example of FIG. 30 is an example in which the imaging device 1 is applied to a side portion of the smart glass SG or under the glass. According to this configuration, functions such as external object recognition and face authentication can be imparted without giving a psychological load to surrounding people.

### [7. Effects]

The imaging device 1 includes the light guide plate 15, the light shielding film 16, and the appearance component 20. The light guide plate 15 has the frustum-shaped protrusion 12. The light shielding film 16 covers a surface of the protrusion 12, the surface being other than the flat face 12A of the top of the protrusion 12. The appearance component 20 covers the upper portion of the light guide plate 15 in a state where the flat face 12A of the protrusion 12 is exposed to the outside.

According to this configuration, the image quality of the imaging device 1 is determined by the shape of the protrusion 12. The appearance component 20 has the opening OP for exposing the flat face 12A of the protrusion 12, but the opening OP does not function as the pinhole PH. Therefore, the processing accuracy of the opening OP does not affect the image quality, and there is no excessive restriction on the processing method. Further, even when the inner wall of the opening OP is peeled off or dust or the like is mixed into the opening OP, the image quality is not affected. Therefore, the image quality of the imaging device 1 is enhanced.

The taper angle θ_{T} of the protrusion 12 is larger than the critical angle θ₂ₜₕ of light incident on the flat face 12A of the protrusion 12.

According to this configuration, light in all directions is guided to the imaging element 30. Therefore, an omnidirectional camera is realized. Furthermore, all the light incident on the flat face 12A is guided to the imaging element 30 through the inside of the side face 12B. Since light reflected by the light shielding film 16 or the inner wall of the opening OP of the appearance component 20 is not generated, good image quality can be obtained.

The light shielding film 16 continuously covers the surface of the light guide plate 15 around the protrusion 12 from the side face 12B of the protrusion 12.

According to this configuration, light traveling toward the imaging element 30 from a portion other than the flat face 12A of the protrusion 12 is well shielded.

The appearance component 20 has an opening OP into which the protrusion 12 is fitted. The opening OP has a tapered shape in which the bottom face side opening area facing the light guide plate 15 is larger than the upper face side opening area. A taper angle θ_{P} of the opening OP is larger than a taper angle θ_{T} of the protrusion 12.

According to this configuration, the opening OP is smoothly fitted with the protrusion 12.

The upper face side opening area of the opening OP is larger than the area of the flat face 12A of the protrusion 12.

According to this configuration, degradation of image quality due to positional displacement between the light guide plate 15 and the appearance component 20 is less likely to occur. In addition, degradation of the angle of view is less likely to occur.

The adhesive layer 60 is provided between the inner face of the opening OP and the side face 12B of the protrusion 12.

According to this configuration, moisture, dust, and the like are hardly mixed into the opening OP.

The side face 12B of the protrusion 12 has a stepwise shape.

According to this configuration, the protrusion 12 can be easily formed by cutting. Furthermore, the light shielding film 16 deposited along the step face has a large thickness with respect to light incident from an oblique direction. Therefore, the light shielding performance is easily secured.

The flat face 12A of the protrusion 12 has an oval shape.

According to this configuration, the imaging device 1 suitable for oblique incident light is provided.

The light guide plate 15 includes a plurality of protrusions 12 whose skirt portions are disposed so as to overlap each other.

According to this configuration, a large number of protrusions 12 can be disposed at high density.

The imaging device 2 includes the imaging element 30 and the filter 40. The imaging element 30 receives light incident from the flat face 12A of the protrusion 12. The filter 40 is disposed on an optical path between the protrusion 12 and the imaging element 30. The filter 40 has such optical characteristics that the transmittance of light decreases toward the center.

According to this configuration, the luminance of light received by the imaging element 30 is made uniform.

The imaging device 4, 5 includes the refractive element RF on an optical path between the protrusion 12 and the imaging element 30 to refract the light transmitted through the protrusion 12 toward the imaging element 30.

According to this configuration, the size of an image to be formed can be reduced. Therefore, the small imaging devices 4 and 5 are provided.

The refractive element RF is the concave lens CL obtained by processing the back face of the light guide plate 15 into a concave shape.

According to this configuration, the number of parts is reduced, and the assembly work is simplified and the cost is reduced.

The upper end portion EG of the light shielding film 16, the upper end portion being adjacent to the flat face 12A, has a shape raised relative to the flat face 12A.

According to this configuration, the light shielding property around the flat face 12A is enhanced.

The imaging device 1 includes the flattening layer 17 that flattens a step between the upper end portion EG of the light shielding film 16 and the flat face 12A on the flat face 12A.

According to this configuration, poor appearance due to excitement is improved. In addition, the stepped portion is less likely to be cracked or chipped.

The upper face 20A of the appearance component 20, the upper face being adjacent to the flat face 12A, is a flat face continuous with the flat face 12A.

According to this configuration, there is no restriction on the angle of view caused by the step between the appearance component 20 and the flat face 12A.

The upper face 20A of the appearance component 20, the upper face being adjacent to the flat face 12A, protrudes upward from the flat face 12A. The imaging device 1 includes, on the flat face 12A, the flattening layer 18 that flattens a step between the upper face 20A of the appearance component 20 and the flat face 12A.

According to this configuration, poor appearance due to excitement is improved. In addition, the stepped portion is less likely to be cracked or chipped.

Further, the effects described in the present identification are merely examples and are not limited, and other effects may be present.

### [Supplementary note]

The present technology may also be configured as below.
(1) An imaging device comprising:
   a light guide plate having a frustum-shaped protrusion;
   a light shielding film covering a surface of the protrusion, the surface being other than a flat face of a top of the protrusion; and
   an appearance component covering an upper portion of the light guide plate in a state where the flat face of the protrusion is exposed to an outside.
(2) The imaging device according to (1), wherein
   a taper angle of the protrusion is larger than a critical angle of light incident on the flat face of the protrusion.
(3) The imaging device according to (1) or (2), wherein
   the light shielding film continuously covers a surface of the light guide plate around the protrusion from a side face of the protrusion.
(4) The imaging device according to any one of (1) to (3), wherein
   the appearance component has an opening into which the protrusion is fitted,
   the opening has a tapered shape in which a bottom face side opening area facing the light guide plate is larger than an upper face side opening area, and
   a taper angle of the opening is larger than a taper angle of the protrusion.
(5) The imaging device according to (4), wherein
   the upper face side opening area of the opening is larger than an area of the flat face of the protrusion.
(6) The imaging device according to (4) or (5), further comprising:
   an adhesive layer between an inner face of the opening and a side face of the protrusion.
(7) The imaging device according to any one of (1) to (6), wherein
   a side face of the protrusion has a stepwise shape.
(8) The imaging device according to any one of (1) to (7), wherein
   the flat face of the protrusion has an oval shape.
(9) The imaging device according to any one of (1) to (8), wherein
   the light guide plate includes a plurality of protrusions whose skirt portions are disposed so as to overlap each other.
(10) The imaging device according to any one of (1) to (9), further comprising:
   an imaging element that receives light incident from the flat face of the protrusion; and
   a filter that is disposed on an optical path between the protrusion and the imaging element and has an optical characteristic such that transmittance of the light decreases toward a center portion.
(11) The imaging device according to (10), further comprising:
   a refractive element that refracts the light transmitted through the protrusion toward the imaging element on the optical path between the protrusion and the imaging element.
(12) The imaging device according to (11), wherein
   the refractive element is a concave lens obtained by processing a back face of the light guide plate into a concave shape.
(13) The imaging device according to any one of (1) to (12), wherein
   an upper end portion of the light shielding film, the upper end portion being adjacent to the flat face, has a shape raised relative to the flat face.
(14) The imaging device according to (13), further comprising:
   a flattening layer, on the flat face, that flattens a step between the upper end portion of the light shielding film and the flat face.
(15) The imaging device according to any one of (1) to (14), wherein
   an upper face of the appearance component, the upper face being adjacent to the flat face, is a flat face continuous with the flat face.
(16) The imaging device according to any one of (1) to (14), wherein
   an upper face of the appearance component, the upper face being adjacent to the flat face, protrudes upward from the flat face, and
   the imaging device further comprises a flattening layer, on the flat face, that flattens a step between the upper face of the appearance component and the flat face.

### Reference Signs List

1 to 5 IMAGING DEVICE
12 PROTRUSION
12A FLAT FACE
15 LIGHT GUIDE PLATE
16 LIGHT SHIELDING FILM
17 FLATTENING LAYER
18 FLATTENING LAYER
20 APPEARANCE COMPONENT
20A UPPER FACE OF APPEARANCE COMPONENT
30 IMAGING ELEMENT
40 FILTER
60 ADHESIVE LAYER
CL CONCAVE LENS
EG UPPER END PORTION OF LIGHT SHIELDING FILM
OP OPENING
RF REFRACTIVE ELEMENT
θ_{P} TAPER ANGLE OF OPENING
θ_{T} TAPER ANGLE OF PROTRUSION

## Claims

1. An imaging device comprising:
a light guide plate having a frustum-shaped protrusion;
a light shielding film covering a surface of the protrusion, the surface being other than a flat face of a top of the protrusion; and
an appearance component covering an upper portion of the light guide plate in a state where the flat face of the protrusion is exposed to an outside.

2. The imaging device according to claim 1, wherein
a taper angle of the protrusion is larger than a critical angle of light incident on the flat face of the protrusion.

3. The imaging device according to claim 1, wherein
the light shielding film continuously covers a surface of the light guide plate around the protrusion from a side face of the protrusion.

4. The imaging device according to claim 1, wherein
the appearance component has an opening into which the protrusion is fitted,
the opening has a tapered shape in which a bottom face side opening area facing the light guide plate is larger than an upper face side opening area, and
a taper angle of the opening is larger than a taper angle of the protrusion.

5. The imaging device according to claim 4, wherein
the upper face side opening area of the opening is larger than an area of the flat face of the protrusion.

6. The imaging device according to claim 4, further comprising:
an adhesive layer between an inner face of the opening and a side face of the protrusion.

7. The imaging device according to claim 1, wherein
a side face of the protrusion has a stepwise shape.

8. The imaging device according to claim 1, wherein
the flat face of the protrusion has an oval shape.

9. The imaging device according to claim 1, wherein
the light guide plate includes a plurality of protrusions whose skirt portions are disposed so as to overlap each other.

10. The imaging device according to claim 1, further comprising:
an imaging element that receives light incident from the flat face of the protrusion; and
a filter that is disposed on an optical path between the protrusion and the imaging element and has an optical characteristic such that transmittance of the light decreases toward a center portion.

11. The imaging device according to claim 10, further comprising:
a refractive element that refracts the light transmitted through the protrusion toward the imaging element on the optical path between the protrusion and the imaging element.

12. The imaging device according to claim 11, wherein
the refractive element is a concave lens obtained by processing a back face of the light guide plate into a concave shape.

13. The imaging device according to claim 1, wherein
an upper end portion of the light shielding film, the upper end portion being adjacent to the flat face, has a shape raised relative to the flat face.

14. The imaging device according to claim 13, further comprising:
a flattening layer, on the flat face, that flattens a step between the upper end portion of the light shielding film and the flat face.

15. The imaging device according to claim 1, wherein
an upper face of the appearance component, the upper face being adjacent to the flat face, is a flat face continuous with the flat face.

16. The imaging device according to claim 1, wherein
an upper face of the appearance component, the upper face being adjacent to the flat face, protrudes upward from the flat face, and
the imaging device further comprises a flattening layer, on the flat face, that flattens a step between the upper face of the appearance component and the flat face.
